# EUROPEAN PATENT APPLICATION

(11) **EP 1 261 037 A1**
(43) Date of publication of application: **27.11.2002**
(21) Application number: 01304660.2
(22) Date of filing: 25.05.2001
(51) Int. Cl.: H01L 31/0232, H01L 33/00

(54) **Package for optoelectronic device and method therefor**

(71) Applicant: Agilent Technologies, Inc. (a Delaware corporation), Palo Alto, CA 94303 (US)
(72) Inventor: Meadowcroft, Simon, Stowmarket, Suffolk, IP14 1TU (GB)
(74) Representative: Coker, David Graeme

(57) **Abstract**

Hermetic seals of packages (2) used to contain oxygen-sensitive materials can fail over a period of time. Contrary to current teachings, the present invention provides an oxygen getter (32) within the package (2) to remove any oxygen leaking into the package (2).

## Description

The present invention relates to a package for an optoelectronic device, the package being of the type used to store oxygen sensitive materials, for example an oxygen sensitive plastic material, such as an optoelectronic modulator formed from the plastic material, in a protective atmosphere, the protective atmosphere being substantially oxygen-free. The present invention also relates to a method of removing oxygen from the protective atmosphere of the above package.

A package for an optoelectronic modulator comprises a housing having the modulator mounted on an optical platform within the housing. In order to maintain stability of the modulator and prolong the life of the modulator, it is known to avoid the presence of oxygen within the housing. Consequently, the housing is filled with any gas that does not react with or 'poison' the modulator, the gas preferably having a high atomic mass, for example Nitrogen, Zeon or Argon. By filling the housing with the inert gas, the housing comprises an oxygen-free atmosphere. The oxygen-free atmosphere is maintained by hermetically sealing the housing. However, the hermetic seal of the housing can fail leading to ingress of oxygen into the housing, thereby contaminating the oxygen-free atmosphere.

In contrast with the practice of avoiding the presence of oxygen in the atmosphere within the housing, US 5, 392, 305, US 5, 629, 952 and US 5, 770, 473 disclose the positive presence of oxygen in controlled amounts in the atmosphere within the housing in order to provide stable, long term, continuous operation of a high-power semiconductor laser. In addition to the provision of oxygen, the above documents disclose the use of a getter to control the amount of impurities (excluding oxygen) within the atmosphere of the housing, such as organic impurities.

According to a first aspect of the present invention, there is provided a package for an optoelectronic device comprising a housing having a substantially oxygen-free gaseous atmosphere hermetically sealed therein, an oxygen-sensitive material located within the housing, and means within the housing for removing oxygen from the gaseous atmosphere so as to prevent oxygen contamination of the gaseous atmosphere in the event of failure of the hermetic seal of the housing.

Preferably, the means for removing oxygen from the gaseous atmosphere is an oxygen getter.

Preferably, the oxygen sensitive material is chemically reactive with oxygen in the presence of electromagnetic energy.

Preferably, the oxygen sensitive material is a polymer material. More preferably, the oxygen sensitive material is a plastic material. Very preferably, the package comprises an optical modulator comprising the oxygen-sensitive material.

Preferably, the substantially oxygen-free gaseous atmosphere comprises an inert gas.

Preferably, the package comprises a laser device located within the housing.

In a preferred embodiment of the invention, there is provided a package for a communications transceiver comprising a housing having: a substantially oxygen-free gaseous atmosphere hermetically sealed therein, a port formed within a wall of the housing for sealingly permitting passage of an optical fibre therethrough into the housing, a clamp for aligning the optical fibre with a plastic modulator located within the housing, a semiconductor laser for launching electromagnetic energy into the plastic modulator, and a lens located between the semiconductor laser and the plastic modulator, the housing being characterised by an oxygen getter located therein for removing oxygen from the gaseous atmosphere so as to prevent oxygen contamination of the gaseous atmosphere in the event of failure of the hermetic seal of the housing.

According to a second aspect of the present invention, there is provided a transceiver device comprising the package as set forth above in relation to the first aspect of the present invention.

According to a third aspect of the present invention, there is provided a method of preventing oxygen ingress into a housing for an optoelectronic device package, the housing comprising a substantially oxygen-free gaseous atmosphere hermetically sealed therein and an oxygen-sensitive material located within the housing, the method comprising the step of: providing means within the housing for removing oxygen from the gaseous atmosphere so as to prevent oxygen contamination of the gaseous atmosphere in the event of failure of the hermetic seal of the housing.

Preferably, the step of providing the means for removing oxygen from the gaseous atmosphere comprises providing an oxygen getter.

At least one embodiment of the invention will now be described, by way of example only, with reference to the accompanying drawing, in which:
**Figure 1** is a schematic diagram of a package constituting a first embodiment of the present invention;
**Figure 2** is a plan view of the package of Figure 1 without a lid;
**Figure 3** is a schematic diagram of a package constituting a second embodiment of the present invention;
**Figure 4** is a plan view of the package of Figure 3 without a lid, and
**Figure 5** is a flow diagram of a method of fabricating the packages of Figurel and/or Figure 3.

Throughout the following description identical reference numerals will be used to identify like parts.

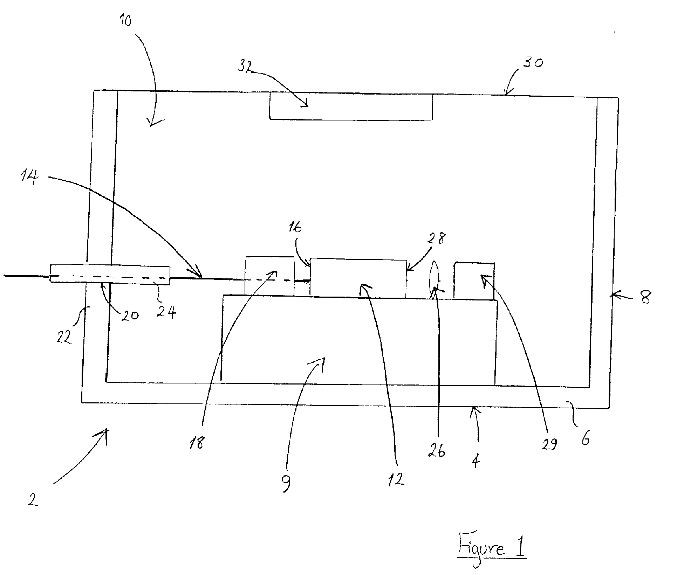

In a first example of the invention (Figure 1), a hermetically sealed package 2 comprises a housing 4 having a base 6 and an upright side wall 8 surrounding the base 6 to define an open chamber 10. A platform 9 is located within the housing 4 adjacent the base 6 to support an optoelectronic modulator 12, in this example, a Mach-Zehnder modulator. A first optical fibre 14 is held adjacent and in alignment with a first side 16 of the modulator 12 by a first saddle 18, the first optical fibre 14 leaving the chamber 10 via a first aperture 20 in a first side 22 of the side wall 8. In this respect, a first gas-proof seal 24 is located within the first aperture 20 to permit the first optical fibre 14 to pass through the first aperture 20 whilst maintaining a gas-proof seal between the first aperture 20 and the first optical fibre 14.

A lens 26 is disposed adjacent a second side 28 of the modulator 12 for focusing electromagnetic radiation onto the second side 28 from a semiconductor laser 29 adjacent the lens 26. In this example, the optoelectronic modulator 12 is a Pacific Wave Communications, LLC modulator sold under the product code PM-1.5-40-201. However, it should be appreciated that any suitable modulator can be used.

A lid 30 comprises an oxygen getter 32, formed, in this example, from iron oxide and is attached to the lid 30 which closes the open chamber 10, the lid 30 being seam welded to a top outer periphery of the side wall 8 so as to create a hermetic seal within the chamber 10. The chamber 10 also comprises an atmosphere. In this example, the atmosphere is an inert gas, but any suitable gas, other than oxygen, that does not react chemically with the modulator 12 or any such oxygen sensitive material, preferably having a high atomic mass, can be used, such as Nitrogen.

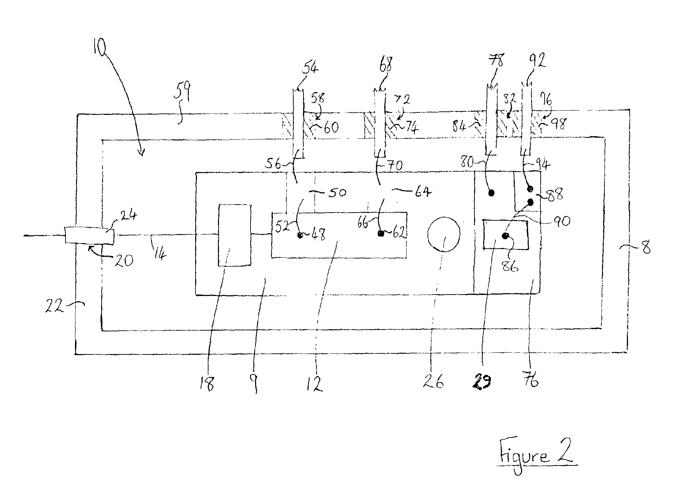

Referring to Figure 2, the modulator 12 comprises a first terminal 48 coupled to a first bond pad 50 via a first bond wire 52. The first bond pad 50 is coupled to a first electrical connector 54 via a second bond wire 56, the first electrical connector 54 passing through a second gas-proof seal 60 located within a second aperture 58 in a second side 59 of the side wall 8. A second terminal 62 of the modulator 12 is coupled to a second bond pad 64 via a third bond wire 66. The second bond pad 64 is coupled to a second electrical connector 68 via a fourth bond wire 70, the second electrical connector 68 passing through a third gas-proof seal 74 located within a third aperture 72 in the second side 59 of the side wall 8. The first and second terminals 48, 62 of the modulator 12 are used to provide modulating electrical signals to the modulator 12.

The laser 29 has a first terminal (not shown) bonded to a third bond pad 76, the third bond pad 76 being coupled to a third electrical connector 78 via a fifth bond wire 80. The third electrical connector 78 passes through a fourth gas-proof seal 84 located within a fourth aperture 82 in the second side 59 of the side wall 8. A second terminal 86 of the laser 29 is coupled to a fourth bond pad 88 via a sixth bond wire 90, the fourth bond pad 88 being electrically insulated from the third bond pad 76. The fourth bond pad 88 is coupled to a fourth electrical connector 92 via a seventh bond wire 94, the fourth electrical connector 92 passing through a fifth gas-proof seal 98 located in a fourth aperture 96 in the second side 59 of the side wall 8.

The first, second, third and fourth electrical connectors 54, 68, 78, 92 are provided in order to provide electrical signals to the modulator 12 and the laser 29.

In this example, the above described parts and components constitute a first set of parts and components.

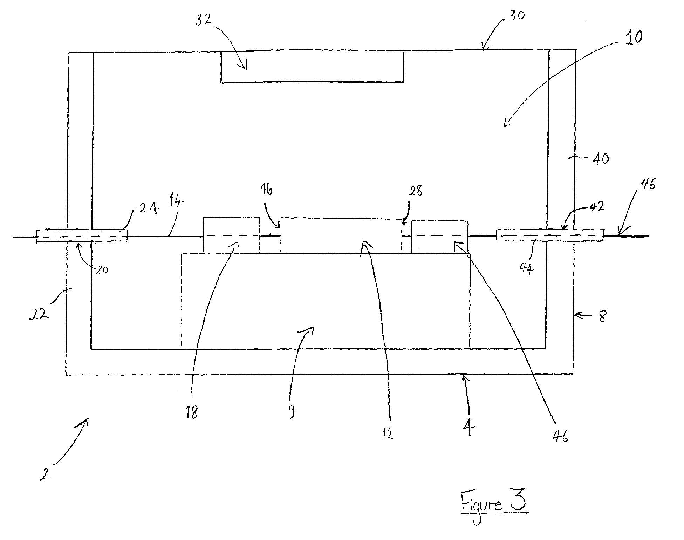

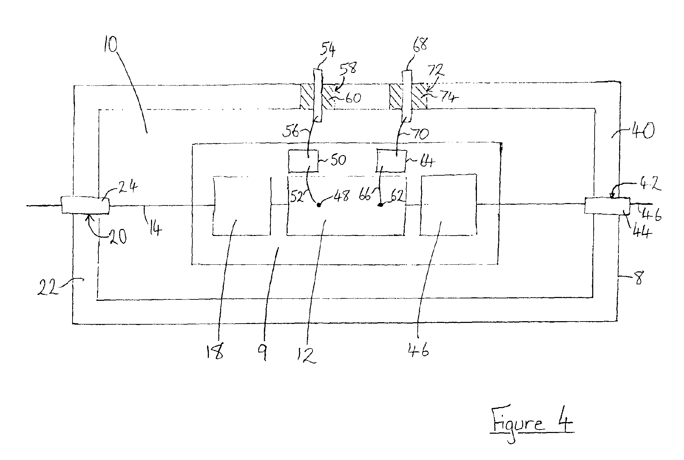

Referring to Figures 3 and 4, in a second example, the package 2 comprises the housing 4 as already described above. Within the housing 4, the chamber 10 comprises the platform 9, the modulator 12, the first saddle 18, the first optical fibre 14, the first aperture 20, the first gas-proof seal 24, the lid 30 and the oxygen getter 32 as already described above in relation to the first example. In addition, instead of the lens 12 and the laser 14, a third side 40 of the side wall 8 comprises a sixth aperture 42 within which is disposed a sixth gas-proof seal 44 in order to permit a second optical fibre 46 to pass through the third side 40 whilst maintaining a gas-proof seal between the sixth aperture 42 and the second optical fibre 46. The second optical fibre 46 is held adjacent the second side 28 of the modulator 12 by a second saddle 46. Since the housing 4 does not contain, in this example, the lens 26 and the laser 29, the third bond pad 76, the fifth bond wire 80, the third electrical terminal 78, the fourth gas-proof seal 84, the fourth aperture 82, the sixth bond wire 90, the fourth bond pad 88, the seventh bond wire 94, the fourth electrical connector 92, the fifth gas-proof seal 98 and the fifth aperture 96 are not provided.

In this example, the parts and components described above in connection with this second example constitute a second set of parts and components.

The package 2 can be coupled, in line, between a pair of optical fibres, such as lens fibres, or between an external semiconductor laser (not shown) and an optical fibre by means of coupling to the first and second optical fibres 14, 46, respectively. It should be appreciated that other coupling configurations are envisaged and it is not intended to limit the invention to the above described coupling configurations.

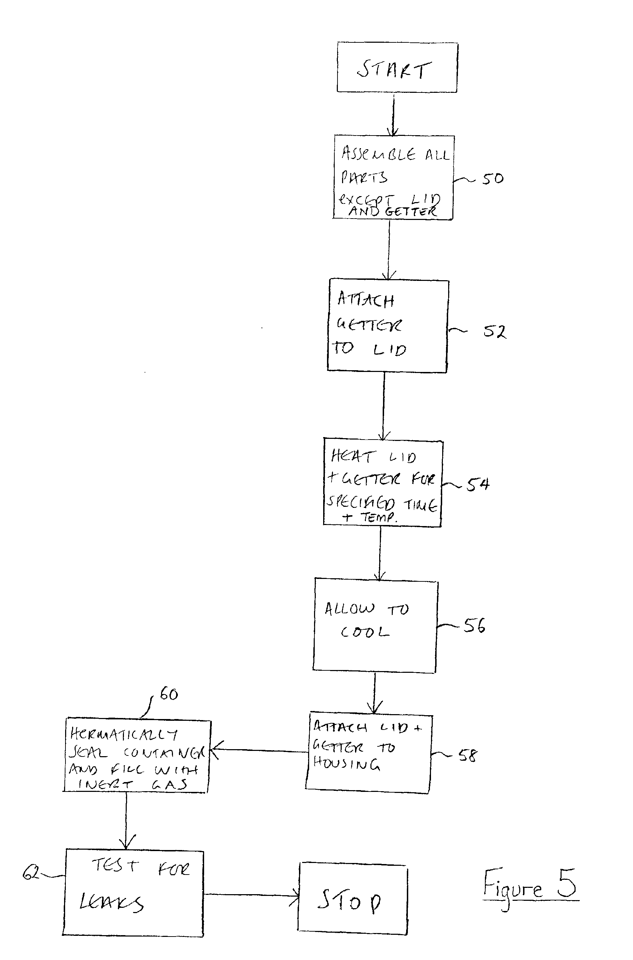

Assembly of the package 2 of Figures 1 and 3 will now be described with reference to Figure 5. It should be noted that while this is the preferred method of construction it is not exclusively limited to the process described.

The housing 4 is initially provided, without the lid 30 and the oxygen getter 32, and the first or second set of parts and components are disposed and anchored within the housing 4 (step 50) depending upon whether construction of the package 4 is required in accordance with to the first example (Figure 1) or the second example (Figure 2).

The oxygen getter 32 is then attached (step 52) to the lid 30. The lid 30 with the oxygen getter 32 attached thereto is then placed (step 54) within an oven at a specified temperature, for example 300°C, and for a specified period of time, for example one hour, in order to activate the oxygen getter 32. The lid 30 and the getter 32 are then allowed to cool (step 56) before attaching (step 58) the lid 30 with the getter 32 to the housing 4. The container is then hermetically sealed (step 60) by seam welding the lid 30 to the housing 4 to close the open chamber 10. The above process of attaching the lid 30 to the housing 4 is carried out in a Nitrogen atmosphere and so the atmosphere within the chamber 10 is Nitrogen. The package 2 is then leak tested using any suitable technique known in the art.

Since the sealing of the package 2 is likely to fail over a period of years, the oxygen getter 32 serves to remove any oxygen entering the housing 4 as a result of a failing seal. Oxygen molecules entering the housing 4 chemically reacts with the oxygen getter 32 formed from iron oxide in accordance with the following chemical reaction: 4FeO +O₂→ 2Fe₂O₃.

Although the above examples have been described in the context of the package 2 containing the oxygen sensitive modulator 12, it should be appreciated that the present invention is applicable to the packaging of any oxygen sensitive material, for example a polymer material, such as a plastic material.

## Claims

1. A package for an optoelectronic device comprising a housing having a substantially oxygen-free gaseous atmosphere hermetically sealed therein, an oxygen-sensitive material located within the housing, and means for removing oxygen from the gaseous atmosphere so as to prevent oxygen contamination of the gaseous atmosphere in the event of failure of the hermetic seal of the housing.

2. A package as claimed in Claim 1, wherein the means for removing oxygen from the gaseous atmosphere is an oxygen getter.

3. A package as claimed in Claim 1 or Claim 2, wherein the oxygen sensitive material is chemically reactive with oxygen in the presence of electromagnetic energy.

4. A package as claimed in any one of the preceding claims, wherein the oxygen sensitive material is a polymer material.

5. A package as claimed in any one of the preceding claims, wherein the oxygen sensitive material is a plastic material.

6. A package as claimed in any one of the preceding claims, further comprising an optical modulator comprising the oxygen-sensitive material.

7. A package as claimed in any one of the preceding claims, wherein the substantially oxygen-free gaseous atmosphere comprises a gas that does not react with the oxygen-sensitive material.

8. A package as claimed in any one of the preceding claims, further comprising a laser device located within the housing.

9. A transceiver device comprising the package as claimed in any one of the preceding claims.

10. A method of preventing oxygen ingress into a housing for an optoelectronic device package, the housing comprising a substantially oxygen-free gaseous atmosphere hermetically sealed therein and an oxygen-sensitive material located within the housing, the method comprising the step of:
providing means for removing oxygen from the gaseous atmosphere so as to prevent oxygen contamination of the gaseous atmosphere in the event of failure of the hermetic seal of the housing.

11. A method as claimed in Claim 10, wherein the step of providing the means for removing oxygen from the gaseous atmosphere comprises providing an oxygen getter.
